# FASCICULE DE BREVET EUROPEEN

(11) **EP 2 647 962 B1**
(45) Date de publication et mention de la délivrance du brevet: **21.03.2018**
(21) Numéro de dépôt: 13162635.0
(22) Date de dépôt: 05.04.2013
(51) Int. Cl.: G01D 4/00, G01D 4/02, G06F 1/26, H01R 13/66, H04Q 9/00, H01R 24/78, G01R 22/06, H02J 13/00, H01R 103/00

(54) **Prise et procédé de contrôle d'une installation électrique comprenant une telle prise**
Steckdose und Kontrollverfahren einer elektrischen Anlage, die eine solche Steckdose umfasst
Socket and method for controlling an electrical installation including such a socket

(30) Priorité: 06.04.2012 FR 1253216
(43) Date de publication de la demande: 09.10.2013
(73) Titulaire: Electricité de France, 75008 Paris (FR)
(72) Inventeur: Pignier, Daniel, 92340 Bourg La Reine (FR); Menga, David, 91370 Verrières le Buisson (FR); Kremers, Enrique Alberto, 76133 Karlsruhe (DE); Casciani, Fabrice, 69006 Lyon (FR)
(74) Mandataire: Cabinet Plasseraud

(56) Documents cités:
- US-A- 5 650 771
- US-A1- 2009 167 537
- US-A1- 2010 033 024
- US-A1- 2010 070 217
- US-B1- 6 292 717

## Description

L'invention concerne le domaine des installations électriques, et plus spécifiquement une prise permettant à un consommateur d'énergie électrique de surveiller et gérer sa consommation.

Les fournisseurs d'énergie électrique proposent à des abonnés - consommateurs d'électricité - des compteurs électriques qui peuvent être munis d'une électronique de gestion.

Par ailleurs, l'installation électrique d'un logement est généralement dotée d'un tableau électrique qui regroupe les commandes de coupure des circuits électriques du logement, les systèmes de protection des circuits ainsi que les protections spécifiques aux personnes. Le tableau électrique peut également intégrer un système de gestion locale de l'énergie consommée, i.e. permettant une programmation des usages des appareils de l'installation selon un paramétrage du consommateur ou selon des consignes de téléinformation délivrées par le compteur électrique en fonction de l'abonnement souscrit.

Les fournisseurs d'énergie électrique cherchent à réguler et à anticiper la consommation électrique chez les abonnés. En effet, les moyens actuels de production d'électricité réagissent difficilement aux fortes variations de la demande en énergie. Les fournisseurs d'énergie électrique cherchent donc à recueillir des informations sur la consommation chez un abonné pour réguler sa consommation par des commandes de téléinformation provenant du compteur. Il existe ainsi des « box » comprenant des modules de prises d'information installés chez un abonné et communiquant des informations au fournisseur de services.

Le document US 7 695 310 décrit une prise qui autorise la fourniture de courant qu'après identification de l'équipement électrique raccordé. La prise décrite dans ce document ne permet pas de collecter des informations relatives aux usages de l'équipement raccordé. Le document US 2011/015795 décrit une prise dans laquelle la puissance délivrée à un équipement électrique est contrôlée par un serveur distant.

Le document US2010/070217 divulgue un dispositif de gestion d'appareils électriques qui se présente sous la forme d'une sur-prise se branchant sur une prise existante en vue d'alimenter des appareils. Le document US5650771 divulgue un dispositif comprenant une ou plusieurs prises électriques comportant un capteur de température afin de détecter les surchauffes. A cet effet, le dispositif comprend un module de gestion contrôlant l'état de fonctionnement du dispositif, sa température, les données de tension et courant aux prises et les données d'alimentation électrique fournies par l'installation du logement. L'unité centrale de gestion est connectée à une alarme de type « buzzer » prévue pour sonner en cas de détection d'une d'anomalie du dispositif, telle qu'une surchauffe. Le document US6292771 concerne un système de gestion énergétique basé sur un disjoncteur et, en vue de contrôler le disjoncteur, comprend une détection de l'alimentation électrique en tension et en courant entre une source électrique et les appareils alimentés. Le disjoncteur proposé émet une alerte en cas d'anomalie détectée. Les systèmes existants ne sont pas contrôlés par l'abonné mais par le fournisseur de service, et ne permettent qu'une collecte partielle d'informations.

Par ailleurs, le tableau électrique appartient au propriétaire du logement. Dans le cas d'un logement en location, le locataire peut accéder aux informations collectées par le tableau électrique le cas échéant. Néanmoins, si le tableau électrique est d'un type ne permettant aucune collecte d'information quant aux usages électriques dans le logement - par soucis d'économies du propriétaire - l'utilisateur du logement ne peut pas contrôler ni gérer ses usages électriques.

Il existe donc un besoin pour un système installé chez un consommateur et contrôlé par ce dernier, qui permette de collecter un ensemble d'informations relatives aux usages chez ce consommateur et de conserver ces informations à la disposition du consommateur.

A cet effet, l'invention propose une prise électrique telle que définie dans les revendications 1 à 5. La prise peut ainsi devenir un maillon d'une plateforme de service du logement, en lieu et place ou en complément du compteur contrôlé par le fournisseur d'énergie électrique et/ou en lieu et place ou en complément du tableau électrique.

Plus particulièrement, l'invention concerne une prise électrique, comprenant :
- au moins un capteur de courant adapté à mesurer un départ de courant et une différence de potentiel ;
- une unité de traitement électronique adaptée à collecter des données du capteur de courant ;
- une mémoire électronique adaptée à archiver les données collectées du capteur de courant ;
- au moins une interface de communication.

Selon les modes de réalisation, la prise selon l'invention peut comprendre en outre une ou plusieurs de caractéristiques suivantes :
- l'unité de traitement électronique est adaptée à collecter et archiver en outre des données d'un moins un capteur domestique ;
- l'unité de traitement électronique est adaptée à collecter et archiver en outre des données de mesure de la fréquence du signal électrique fourni par un réseau électrique ;
- l'unité de traitement électronique est paramétrée pour détecter une baisse de la fréquence du signal électrique fourni par le réseau électrique et adaptée à commander un effacement du courant fourni à un équipement ;
- l'unité de traitement électronique est adaptée à transmettre, sur requête, des données collectées et archivées ;
- l'unité de traitement électronique est paramétrée pour détecter des anomalies de fonctionnement à partir des données collectées et adaptée à émettre une alerte ;
- l'interface de communication est au moins une parmi une connexion radio, une connexion WiFi, un canal CPL ;
- une source de puissance autonome ;

L'invention concerne aussi une installation électrique domestique telle que définie dans les revendications 6 à 8. L'invention concerne également un procédé de contrôle tel que défini dans les revendications 9 à 13, le procédé comprenant les étapes de :
- collecte et archivage des données des capteurs ;
- transmission, sur requête, des données collectées et archivées ;
- consultation, sur requête, des données collectées et archivées.

Selon un mode de réalisation, le procédé de contrôle selon l'invention comprend en outre les étapes de :
- surveillance des données collectées pour détecter des anomalies de fonctionnement ;
- émission d'une alerte en cas d'anomalie détectée.

Selon un mode de réalisation, le procédé de contrôle selon l'invention comprend en outre une étape de surveillance de la fréquence du signal électrique fourni par un réseau électrique et une étape d'effacement du courant fourni à un équipement lorsqu'une baisse de fréquence est détectée. Selon les modes de mise en oeuvre, l'étape d'effacement peut être commandée par le réseau électrique, par l'unité de traitement électronique de la prise ou par un utilisateur.

L'installation peut comprendre une pluralité d'unités de traitement électroniques, le procédé comprenant alors en outre l'étape de choix d'une des unités comme unité maitre.

D'autres caractéristiques et avantages de l'invention apparaîtront à la lecture de la description détaillée ci-après, et des figures annexées qui représentent :
- figure 1, une prise électrique selon l'invention ;
- figure 2, un exemple d'installation comprenant une prise selon l'invention.

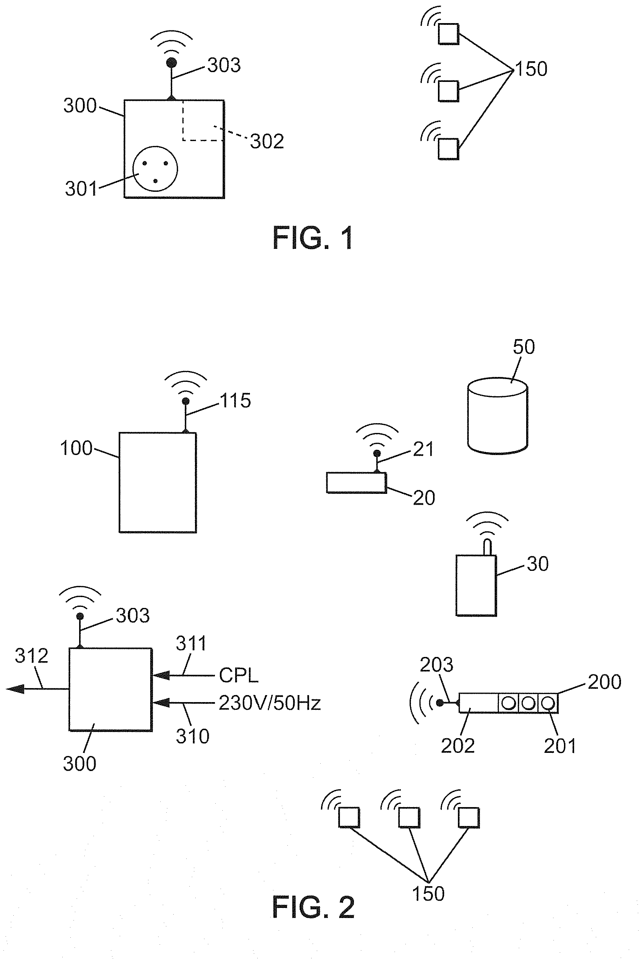

La figure 1 montre une prise 300 installée dans un logement d'un consommateur d'énergie électrique, c'est-à-dire en aval d'un compteur électrique et d'un tableau électrique.

La prise 300 selon l'invention comprend au moins un capteur de courant 301. On peut prévoir de placer deux capteurs de courant pour mesurer d'une part un départ et d'autre part un retour de courant. Le capteur de courant 301 est ainsi adapté à mesurer un départ de courant et une différence de potentiel au niveau de la prise. Tout défaut électrique intervenant dans l'équipement branché à la prise peut ainsi être détecté au moyen du capteur 301, comme un défaut de court-circuit ou surintensité, ou un défaut de fuite de courant sur l'équipement branché à la prise 300 ou un défaut de non fonctionnement de l'équipement.

La prise 300 selon l'invention comprend en outre une unité de traitement électronique 302 collectant des données du capteur de courant 301. Ces données sont collectées puis archivées dans une mémoire dans la prise. Une telle mémoire peut être une carte « microSD » (microcarte Digitale Sécurisée) insérée dans la prise. La prise 300 constitue ainsi une « boîte noire » des usages électriques de l'équipement branché sur cette prise. Le capteur de courant 301 recueille des informations relatives à la consommation de l'appareil ou groupe d'appareils raccordé à la prise et l'unité de traitement électronique 302 collecte et archive ces données. Le consommateur peut alors choisir de la manière dont il dispose de ces informations collectées et archivées.

Notamment, la prise 300 comprend au moins une interface de communication 303. Une telle interface de communication 303 peut comprendre au moins une parmi une connexion radio, une connexion WiFi, une connexion CPL (Courant Porteur de Ligne) ou toute autre interface permettant au consommateur de consulter les informations collectées et archivées et/ou permettant un transfert de ces informations vers une unité extérieure. Par exemple, les données collectées et archivées dans la mémoire de la prise 300 peuvent être dupliquées automatiquement vers le tableau électrique du logement ou vers un coffre fort électronique sécurisé avec une fréquence déterminée selon un paramétrage du consommateur. Les données collectées et archivées dans la mémoire de la prise 300 peuvent être transférées ou consultées, sur requête, depuis un ordinateur ou tout autre dispositif muni d'un logiciel adapté.

L'interface de communication 303 peut aussi permettre de recueillir des informations complémentaires dans l'installation, comme cela sera décrit en référence à la figure 2.

La prise 300 selon l'invention permet à un consommateur de contrôler certains de ses usages électriques et de conserver un historique de ces usages. Par exemple, les données collectées par le capteur de courant 301 et archivées dans la mémoire de la prise peuvent être consultées par le consommateur (propriétaire et maitre de la prise contrairement au compteur qui est contrôlé par le fournisseur d'énergie électrique) et transmises vers l'extérieure sur requête du consommateur. La requête de transmission vers l'extérieure des données collectées peut être ponctuelle ou le fait d'un paramétrage par le consommateur, pour une sauvegarde régulière des données par exemple.

Les usages électriques du consommateur peuvent ainsi être conservés à l'extérieur du logement et reconstitués, par exemple pour assister le consommateur dans l'optimisation de sa consommation électrique et/ou pour aider à établir des causes de défaillances en cas de sinistre.

Selon un mode de réalisation, l'unité de traitement électronique 301 de la prise 300 peut en outre être paramétrée pour détecter des anomalies de fonctionnement à partir des données collectées, notamment un défaut de fuite de courant ou de court-circuit et/ou le non fonctionnement de l'équipement raccordé à la prise. L'unité de traitement électronique 301 peut alors émettre une alerte à l'attention du consommateur via l'interface 303 de communication.

Selon un mode de réalisation, la prise 300 comprend en outre un moyen de mesure de la fréquence du signal électrique fourni par le réseau. Typiquement, en France, les fournisseurs d'électricité fournissent un signal électrique en courant alternatif à 50 Hz sur 220V. L'unité de traitement électronique 302 de la prise 300 peut en outre être paramétrée pour détecter des variations dans la fréquence du signal électrique du réseau. Une telle situation peut notamment se produire sur de petits réseaux non interconnectés, comme ceux des territoires d'outre-mer par exemple, où les variations de demandes peuvent impacter la fréquence du signal électrique.

En particulier, l'unité de traitement électronique 302 peut être paramétrée pour détecter une baisse de la fréquence du signal électrique fourni par le réseau électrique ; elle peut alors commander un effacement du courant fourni à l'équipement. La prise 300 selon l'invention conserve en effet un historique de fonctionnement électrique de l'équipement raccordé - au moyen des données collectées et archivées en provenance du capteur de courant 301. L'unité de traitement électronique 302 est alors en mesure de déterminer, à un instant donné, si l'équipement peut accepter un effacement temporaire sans nuire à son bon fonctionnement, par exemple par un changement de consigne du chauffage ou une coupure d'alimentation du réfrigérateur si un cycle de compression vient de se terminer. L'unité de traitement électronique 302 peut également émettre une alerte à l'attention du consommateur via l'interface 303 de communication, l'informant d'une baisse de fréquence dans le réseau. Selon les modes de réalisation, l'effacement peut être commandé par le consommateur lui-même ou ce dernier est simplement informé qu'un effacement a été commandé par le réseau ou qu'un effacement a été automatiquement décidé par la prise.

Les données relatives à la mesure de la fréquence du signal électrique fourni par le réseau électrique peuvent en outre être archivées dans la mémoire de la prise 300 au même titre que les données collectées du capteur de courant 301. Le consommateur peut ainsi savoir quand et combien de temps son équipement raccordé a subi un effacement en courant.

La figure 2 montre une installation comprenant la prise 300 décrite en référence à la figure 1.

La figure 2 montre une pluralité de capteurs domestiques 150. Ces capteurs domestiques 150 peuvent être installés dans le logement à la discrétion du consommateur ; ils peuvent inclure des capteurs d'humidité, de fumée, de qualité de l'air, de luminosité, de mouvement ou autre. L'unité de traitement électronique 302 de la prise 300 peut collecter et archiver en outre ces données recueillies par les capteurs domestiques 150. Un canal radio de l'interface de communication 303 de la prise 300 peut par exemple être utilisé à cet effet.

Les données ainsi collectées des capteurs domestiques 150 sont également archivées dans la mémoire de la prise 300, au même titre que les données collectées du capteur de courant 301, et peuvent être consultées par le consommateur et transmises vers l'extérieure sur requête du consommateur. Ces données collectées des capteurs domestiques 150 sont intégrées dans l'historique des usages du logement et peuvent ensuite servir au besoin à reconstituer des événements intervenus dans le logement.

Selon un mode de réalisation, l'unité de traitement électronique 302 peut également être paramétrée pour détecter des anomalies de fonctionnement à partir des données collectées des capteurs domestiques 150, par exemple un défaut de qualité de l'air ou une détection d'intrusion. L'unité de traitement électronique 302 peut alors émettre une alerte à l'attention du consommateur ou d'un tiers via l'interface 303 de communication.

Si l'installation comprend une pluralité de prises 300 selon l'invention, c'est-à-dire une pluralité d'unités de traitement électroniques 302, une des unités peut alors être choisie comme unité maitre d'une zone géographique. L'unité maitre peut collecter les données provenant des capteurs domestiques 150 et/ou rassembler l'ensemble des données collectées par les autres unités de traitement électroniques des autres prises de cette zone géographique. En cas de défaillance de l'unité maitre, une autre des unités de traitement électroniques opérationnelle de cette zone géographique peut être élue comme unité maitre selon des procédés de communication entre unités électroniques connus en soi.

Les données collectées par chaque prise 300 peuvent être transmises vers un tableau électrique 100 du logement muni d'une interface de communication 115, notamment lorsque le consommateur peut également contrôler le tableau électrique (dans le cas d'un propriétaire habitant son logement par exemple). Le tableau électrique 100 peut comprendre une unité de traitement électronique recueillant l'ensemble des données collectées par une pluralité de prises 300 selon l'invention et consolidant ces données pour archivage et transmission vers l'extérieur du logement.

Par exemple, l'unité de traitement électronique 302 de la prise 300 peut transmettre à l'unité de traitement électronique du tableau 100 l'ensemble de ses données collectées et archivées - données collectées par le capteur de courant 301 et données collectées des capteurs domestiques 150 locaux. Le consommateur peut accéder aux données collectées par la prise 300 soit par le tableau, soit directement en interrogeant la prise à l'aide d'un dispositif communiquant 30 (tablette, PC, Smartphone ou autre) muni d'un logiciel adapté. Les données collectées et archivées dans la mémoire de chaque prise 300 peuvent être transmises régulièrement vers le tableau électrique 100 et/ou dupliquées automatiquement dans un coffre fort électronique sécurisé 50 avec une fréquence déterminée selon un paramétrage du consommateur.

L'installation peut comprendre en outre une ou plusieurs multiprises 200 installées dans le logement, chaque multiprise 200 comprenant au moins un capteur de courant 201 par prise pour mesurer un départ de courant et une différence de potentiel au niveau de chaque prise de la multiprise. La multiprise 200 comprend également une unité de traitement électronique 202 collectant des données des capteurs de courant 201 et une mémoire archivant les données ainsi collectées. La multiprise comprend en outre au moins une interface de communication 203, qui peut être une connexion radio, une connexion WiFi, une connexion CPL (Courant Porteur de Ligne) ou toute autre interface permettant au consommateur de consulter les informations collectées et archivées et/ou permettant un transfert de ces informations vers une unité extérieure.

Comme décrit plus haut en référence à la prise 300, la multiprise 200 peut également relayer la collecte de données provenant de capteurs domestiques 150. L'ensemble des données collectées par la multiprise 200 - données des capteurs de courant 201 et données collectées des capteurs domestiques 150 locaux - peuvent être transmises à l'unité de traitement électronique du tableau 100 et/ou à l'unité de traitement électronique d'une prise 300 selon l'invention. Les données collectées par la multiprise 200 peuvent aussi être consultées localement dans la multiprise 200 par le consommateur à l'aide d'un dispositif communiquant 30 muni d'un logiciel adapté.

Le tableau électrique 100 peut présenter un port USB pour permettre une mise à jour et/ou une maintenance des logiciels de l'unité de traitement électronique 302 de chaque prise 300. Une interface homme-machine (IHM) peut permettre une consultation in situ des données collectées et archivées par l'unité de traitement électronique du tableau après authentification du consommateur (saisi d'un code et/ou d'une donnée biométrique par exemple) et/ou pour permettre un paramétrage par le consommateur. Le paramétrage des prises 300 peut également être réalisé par le consommateur à l'aide d'un dispositif communiquant en Wifi, en CPL ou par radio, via l'interface 303 de la prise 300. Un tel dispositif 30 peut être une tablette, un PC, un Smartphone ou autre, munis d'un logiciel adapté.

La prise 300 selon l'invention peut être utilisée pour contrôler une installation électrique domestique.

Un tel contrôle comprend la collecte de données à partir de capteurs 150, 301 (capteurs de courant et capteurs domestiques le cas échéant, collecte centralisée au niveau d'une prise ou collecte relayée par prises locales le cas échéant) et l'archivage de ces données (dans la mémoire de chaque prise 300). Les données collectées peuvent être horodatées par l'unité de traitement électronique 302 assurant l'archivage.

Les solutions existantes, limitées en points de mesure de consommation d'usages, ne permettent pas de traiter la sécurité électrique, ni le confort et la qualité de bien être des occupants d'un logement.

Si plusieurs prises 300 selon l'invention, et éventuellement plusieurs multiprises 200, sont présentes dans une zone géographique du logement - chambre, cuisine, séjour, ..., c'est à dire si plusieurs unités de traitement électroniques 302 sont impliquées dans la collecte et l'archivage des données des capteurs d'une même zone géographique, une étape de choix d'une unité maitre pour cette zone géographique peut être réalisée pour coordonner la collecte et l'archivage des données, ainsi que la consultation des données archivées et leur transmission vers l'extérieur. L'élection d'une unité de traitement électronique comme unité maitre peut être faite de toute manière connue en soi. Si l'unité maitre choisie venait à être défaillante, une nouvelle élection d'une unité maitre parmi les unités électroniques opérationnelles de cette zone géographique interviendrait, de manière connue en soi.

La collecte des données comprend également la mesure de la fréquence du signal électrique 310 fourni par le réseau, ainsi que l'archivage de ces données. Comme expliqué plus haut, l'unité de traitement électronique 302 peut être paramétrée pour détecter des anomalies dans les données récoltées du réseau, notamment une baisse de fréquence du courant alternatif délivré par le réseau. Elle peut alors être paramétrée pour commander un effacement de l'équipement raccordé en envoyant une commande par une interface dédiée 312 qui peut être un fil pilote (dans le cas d'un chauffage par exemple), ou une liaison infrarouge (dans le cas d'un climatiseur par exemple), ou un pilotage par relais (dans le cas d'un réfrigérateur par exemple), ou encore en utilisant l'interface de communication 303 par connexion radio, wifi ou CPL. L'effacement peut être décidé par l'unité de traitement électronique 302 automatiquement en fonction des données collectées - du réseau et de l'historique des usages électriques de l'équipement raccordé - ou l'effacement peut être commandé par le réseau par une commande CPL 311 dédiée. L'effacement peut encore être commandé par le consommateur lui-même qui envoi, via l'interface de communication 303, son accord à l'unité électronique de traitement 302 pour une commande d'effacement sur réception d'une alerte l'informant d'un défaut dans le réseau.

La commande d'effacement peut consister dans une coupure momentanée de l'alimentation électrique de l'équipement raccordé (par exemple dans le cas d'une commande par relais), ou la commande d'effacement peut consister dans une modification momentanée de la consigne de l'équipement raccordé (par exemple dans le cas d'une commande par fil pilote).

Le contrôle d'une installation électrique selon l'invention comprend également la transmission et/ou la consultation, sur requête, des données collectées et archivées.

Par exemple, les données collectées sont stockées sur une carte µSD directement dans chacune des mémoires des unités de traitement électroniques, pour une durée glissante prédéterminée (quelques semaines ou quelques mois selon les paramétrages). Ces données peuvent alors être cycliquement dupliquées dans un coffre fort électronique sécurisé 50, extérieur au logement, sans limitation de durée. Le transfert de ces données peut être crypté et transiter via un boîtier télécom 20 avec une liaison ADSL. Un tel boitier télécom 20 comprend une interface de communication 21 qui peut communiquer avec l'interface de communication 303 de chaque prise 300. Le cas échéant, le boîtier télécom 20 peut aussi communiquer avec l'interface de communication 115 du tableau 100 en Wifi ou par un câble Ethernet.

Dans le cas d'une coupure électrique générale, chaque unité de traitement électronique peut posséder une autonomie suffisante pour sauvegarder les données et envoyer une alerte au consommateur ou à un tiers. Un dispositif automatique peut alors mettre en sommeil les capteurs et interrompre la collecte de données.

On peut prévoir une source de puissance autonome dans la prise 300 afin de maintenir la détection d'anomalies dans le logement en cas de coupure électrique générale. Par exemple, la prise 300 peut comprendre une batterie rechargeable assurant un fonctionnement dégradé en absence d'alimentation externe (par exemple en cas de perte totale des alimentations (12V DC sur secteur)).

Les solutions existantes ne permettent pas de fonctionner en mode dégradé. Si la « box » tombe en panne, plus aucune fonction n'est assurée.

Le consommateur peut aussi requérir, au moyen d'un dispositif communiquant muni d'un logiciel adapté (Smartphone 30 par exemple, PC ou autre), de consulter les données archivées dans chacune des mémoires des unités de traitement électroniques des prises 300. L'interface 303 permet de lire les données collectées, de les traiter, de les mettre en forme afin de permettre la mise en place de services à valeurs ajoutées personnalisés. L'interface 303 permet également à un consommateur de paramétrer la prise 300 selon l'invention. Le paramétrage de chaque prise 300 peut comprendre les renseignements suivants :
- le type d'équipement raccordé (ECS, congélateur, chauffage électrique, climatisation, ...),
- le type de pilotage qui lui est associé (ON/OFF, Consigne, ...),
- le calibre amont du disjoncteur (10 A, 16A, ...) auquel il associé,
- le type de contrat électrique souscrit par le consommateur (Base, HC/HP, ...),
- la date et l'heure,
- la configuration des liaisons de communication avec les interfaces IHM des habitants (paramétrage du Wifi), avec le tableau électrique si présent, avec l'opérateur du réseau électrique pour recevoir d'une part le signal d'effacement en provenance de l'opérateur et pour transmettre à ce dernier le potentiel d'effacement à tout moment du logement....

Les mesures de courant de chaque prise 300 permettent de recueillir des informations de consommation détaillée pour un équipement donné et de suivre les cycles de fonctionnement de l'équipement. Ces informations permettent au consommateur de se sensibiliser, de gérer et d'optimiser sa consommation d'énergie dans son logement et d'avoir accès à un bilan détaillé de sa consommation électrique (au même titre qu'une facture de télécommunication ou d'un relevé bancaire mensuel de ses transactions).

Les solutions existantes centralisent les informations sur des serveurs externes contrôlés par les fournisseurs de services pour créer les plateformes de services : ce sont des solutions intrusives où le consommateur n'a pas la maitrise de ses données.

Le contrôle d'une installation électrique selon l'invention comprend également la surveillance des données collectées pour détecter des anomalies de fonctionnement et l'émission d'une alerte en cas d'anomalie détectée.

Chaque unité de traitement électronique 302 peut être paramétrée pour détecter des anomalies dans les données récoltées des capteurs 301, 150. Elle peut alors envoyer des alertes au consommateur ou à un tiers paramétré sur déclenchement d'événements qui peuvent être :
- défaut de court circuit ou sur-intensité,
- défaut de fuite de courant sur l'équipement,
- défaut non fonctionnement d'un équipement : aucune consommation mesurée malgré un ordre d'activation,
- défaut qualité de l'air, de température, d'humidité, de fuite d'eau,
- déclenchement d'une alarme d'intrusion ;
- défaut alerte inactivité : santé

Chaque unité de traitement électronique 302 peut en outre être paramétrée pour détecter des anomalies dans les données récoltées du réseau, notamment une baisse de fréquence du courant alternatif délivré par le réseau. Elle peut alors commander un effacement de l'équipement raccordé et/ou envoyer des alertes au consommateur ou à un tiers paramétré. A cet effet, l'unité de traitement électronique 302 conserve l'historique des cycles de fonctionnement de l'équipement pour calculer son autonomie disponible s'il n'est plus alimenté (notamment dans le cas d'un réfrigérateur, congélateur, ECS ...).

La prise courant 300 selon l'invention peut, en fonction du paramétrage du consommateur :
- effacer ou enclencher l'équipement de façon autonome, en fonction de la qualité du réseau électrique,
- effacer ou enclencher l'équipement sur un signal en provenance de l'opérateur du réseau électrique ;
- effacer ou enclencher l'équipement sur action de l'utilisateur

En fonction du type et de la technologie de l'équipement raccordé, l'effacement ou l'enclenchement pourra se faire :
- par relais (ON / OFF),
- par modification de la consigne de température (fil pilote, infra rouge, ...)

Les solutions existantes ne permettent pas de traiter la sécurité électrique et sont encore limitées sur le traitement de la qualité de l'environnement d'un logement. Les solutions existantes ne permettent pas non plus de connaître la qualité du réseau électrique, d'analyser le fonctionnement des équipements pour prendre de façon autonome des décisions locales de pilotage. Les solutions existantes reposent sur la « box » de l'opérateur de services pour la prise de décision.

En cas de perte totale des alimentations (12V DC sur secteur) avec passage sur batterie dans la prise 300, un premier message peut être envoyé sur l'une des interfaces du consommateur et un second message peut être envoyé à l'unité de traitement électronique du tableau électrique 100 du logement ou d'une autre prise de courant, le cas échéant.

Le consommateur peut ainsi gérer de manière personnalisée ses usages électriques et conserver de manière sécurisée un historique de données liées à son logement.

L'invention a été décrite en référence à des modes de réalisations particuliers qui ne sont pas limitatifs. Notamment, le nombre et la nature des capteurs peuvent varier selon les applications, ainsi que les modes de transmission et de consultation des données collectées.

## Revendications

1. Prise électrique (300), comprenant :
- au moins un capteur de courant (301) adapté à mesurer un départ de courant et une différence de potentiel ;
- une unité de traitement électronique (302) adaptée à collecter des données du capteur de courant ;
- une mémoire électronique adaptée à archiver les données collectées du capteur de courant ;
- au moins une interface de communication (303), et
dans laquelle l'unité de traitement électronique est :
- paramétrée pour détecter des anomalies de fonctionnement à partir des données collectées et adaptée à émettre une alerte ;
- adaptée à collecter et archiver en outre des données de mesure de la fréquence du signal électrique fourni par un réseau électrique ; et
- paramétrée pour détecter une baisse de la fréquence du signal électrique fourni par le réseau électrique et adaptée à commander un effacement du courant fourni à un équipement.

2. Prise électrique selon la revendication 1, dans laquelle l'unité de traitement électronique est adaptée à collecter et archiver en outre des données d'un moins un capteur domestique (150).

3. Prise électrique selon l'une quelconque des revendications précédentes, dans laquelle l'unité de traitement électronique est adaptée à transmettre, sur requête, des données collectées et archivées.

4. Prise électrique selon l'une quelconque des revendications précédentes, dans lequel l'interface de communication est au moins une parmi une connexion radio, une connexion WiFi, un canal CPL.

5. Prise électrique selon l'une quelconque des revendications précédentes, comprenant en outre une source de puissance autonome.

6. Installation électrique domestique, comprenant au moins une prise électrique (300) selon l'une des revendications 1 à 5.

7. L'installation électrique selon la revendication 6, comprenant en outre au moins un capteur domestique (150).

8. L'installation électrique selon l'une des revendications 6 ou 7, comprenant en outre au moins un dispositif (30) comprenant une application logicielle permettant de consulter l'ensemble des données collectées et archivées.

9. Procédé de contrôle d'une installation électrique domestique selon l'une des revendications 6 à 8, le procédé comprenant les étapes de :
- collecte et archivage des données des capteurs ;
- transmission, sur requête, des données collectées et archivées ;
- consultation, sur requête, des données collectées et archivées ;
- surveillance des données collectées pour détecter des anomalies de fonctionnement ;
- émission d'une alerte en cas d'anomalie détectée comprenant en outre une étape de surveillance de la fréquence du signal électrique fourni par un réseau électrique et une étape d'effacement du courant fourni à un équipement lorsqu'une baisse de fréquence est détectée.

10. Procédé de contrôle selon la revendication 9, dans lequel l'étape d'effacement est commandée par le réseau électrique.

11. Procédé de contrôle selon la revendication 9, dans lequel l'étape d'effacement est commandée par l'unité de traitement électronique de la prise.

12. Procédé de contrôle selon la revendication 9, dans lequel l'étape d'effacement est commandée par un utilisateur.

13. Procédé de contrôle selon l'une des revendications 9 à 12, l'installation comprenant une pluralité d'unités de traitement électroniques, le procédé comprenant en outre l'étape de choix d'une des unités comme unité maitre.

## Patentansprüche

1. Steckdose (300), umfassend:
- mindestens einen Stromfühler (301), der geeignet ist, einen Stromausgang und einen Potentialunterschied zu messen;
- eine elektronische Verarbeitungseinheit (302), die geeignet ist, Daten von dem Stromfühler zu sammeln,
- einen elektronischen Speicher, der geeignet ist, die gesammelten Daten des Stromfühlers zu archivieren;
- mindestens eine Kommunikationsschnittstelle (303), und
wobei die elektronische Verarbeitungseinheit:
- parametriert ist, um Funktionsanomalien aus den gesammelten Daten zu erfassen, und geeignet ist, einen Alarm zu senden;
- geeignet ist, ferner Messdaten der Frequenz des von einem elektrischen Netz gelieferten elektrischen Signals zu sammeln und zu archivieren; und
- parametriert ist, um einen Abfall der Frequenz des von dem elektrischen Netz gelieferten Signals zu erfassen, und geeignet ist, ein Löschen des an eine Ausrüstung gelieferten Stroms zu steuern.

2. Steckdose nach Anspruch 1, bei der die elektronische Verarbeitungseinheit geeignet ist, ferner Daten mindestens eines Haussensors (150) zu sammeln und archivieren.

3. Steckdose nach einem der vorhergehenden Ansprüche, bei der die elektronische Verarbeitungseinheit geeignet ist, auf Anfrage gesammelte und archivierte Daten zu übertragen.

4. Steckdose nach einem der vorhergehenden Ansprüche, bei der die Kommunikationsschnittstelle mindestens eine unter einem Funkanschluss, einem WiFi-Anschluss, einem CPL-Kanal ist.

5. Steckdose nach einem der vorhergehenden Ansprüche, ferner umfassend eine autonome Leistungsquelle.

6. Elektrische Hausanlage, umfassend mindestens eine Steckdose (300) nach einem der Ansprüche 1 bis 5.

7. Elektrische Anlage nach Anspruch 6, ferner umfassend mindestens einen Haussensor (150).

8. Elektrische Anlage nach einem der Ansprüche 6 oder 7, ferner umfassend mindestens eine Vorrichtung (30), umfassend eine Software-Anwendung, die es ermöglicht, die Gesamtheit der gesammelten und archivierten Daten zu konsultieren.

9. Verfahren zur Steuerung einer elektrischen Hausanlage nach einem der Ansprüche 6 bis 8, wobei das Verfahren die folgenden Schritte umfasst:
- Sammeln und Archivieren der Daten der Sensoren;
- auf Anfrage Übertragung der gesammelten und archivierten Daten;
- auf Anfrage Konsultation der gesammelten und archivierten Daten;
- Überwachung der gesammelten Daten, um Funktionsanomalien zu erfassen;
- Senden eines Alarms im Falle einer erfassten Anomalie,
ferner umfassend einen Schritt der Überwachung der Frequenz des von einem elektrischen Netz gelieferten elektrischen Signals und einen Schritt des Löschens des an eine Ausrüstung gelieferten Stroms, wenn ein Frequenzabfall erfasst wird.

10. Steuerungsverfahren nach Anspruch 9, bei dem der Schritt des Löschens von dem elektrischen Netz gesteuert wird.

11. Steuerungsverfahren nach Anspruch 9, bei dem der Schritt des Löschens von der elektronischen Verarbeitungseinheit der Steckdose gesteuert wird.

12. Steuerungsverfahren nach Anspruch 9, bei dem der Schritt des Löschens von einem Benutzer gesteuert wird.

13. Steuerungsverfahren nach einem der Ansprüche 9 bis 12, wobei die Anlage eine Vielzahl von elektronischen Verarbeitungseinheiten umfasst, wobei das Verfahren ferner den Schritt der Auswahl einer der Einheiten als Master-Einheit umfasst.

## Claims

1. Electrical socket (300), comprising:
- at least one current sensor (301) suited for measuring an outgoing current and a potential difference;
- an electronic processing unit (302) suitable for collecting data from the current sensor;
- an electronic memory suitable for archiving the data collected from the current sensor;
- at least one communication interface (303), and
wherein the electronic processing unit is:
- configured for detecting malfunctions from the collected data and suitable for emitting an alert;
- also suitable for collecting and archiving measurement data on the frequency of the electric signal provided by an electric network; and
- configured for detecting a frequency dip of the electric signal provided by the electric network and suitable for actuating a curtailment of the current supplied to an equipment item.

2. Electrical socket according to claim 1, wherein the electronic processing unit is also suitable for collecting and archiving data from at least one home sensor (150).

3. Electrical socket according to any of the previous claims, wherein the electronic processing unit is suitable for transmitting, upon request, the collected and archived data.

4. Electrical socket according to any of the previous claims, wherein the communication interface is at least included in the group formed from a radio connection, a Wi-Fi connection and a powerline communication channel.

5. Electrical socket according to any of the previous claims, further comprising an autonomous power source.

6. Household electrical installation comprising at least one electrical socket (300) according to one of claims 1 to 5.

7. Electrical installation according to claim 6, further comprising at least one home sensor (150).

8. Electrical installation according to either claim 6 or claim 7, further comprising at least one device (30) comprising a software application allowing all of the collected and archived data to be viewed.

9. Method for controlling a household electrical installation according to one of claims 6 to 8, said method comprising the steps of:
- collecting and archiving data from the sensors;
- transmitting, upon request, collected and archived data;
- viewing, upon request, collected and archived data;
- monitoring collected data in order to detect malfunctions;
- emitting an alert in the event of a detected malfunction further comprising a step of monitoring the frequency of the electric signal provided by an electric network and a step of curtailing the current supplied to an equipment item when a frequency dip is detected.

10. Control method according to claim 9, wherein the curtailment step is actuated by the electric network.

11. Control method according to claim 9, wherein the curtailment step is actuated by the electronic processing unit of the socket.

12. Control method according to claim 9, wherein the curtailment step is actuated by a user.

13. Control method according to one of claims 9 to 12, whereby the installation comprises a plurality of electronic processing units, the method further comprising the step of selecting one of the units as a master unit.
